(19) Europäisches Patentamt
European Patent Office
Office européen des brevets

(11) **EP 4 411 451 A1**

(12) **EUROPEAN PATENT APPLICATION**
published in accordance with Art. 153(4) EPC

(43) Date of publication:
**07.08.2024 Bulletin 2024/32**

(21) Application number: **22875712.6**

(22) Date of filing: **01.09.2022**

(51) International Patent Classification (IPC):
**G02B 26/10** (2006.01)   **B81B 3/00** (2006.01)
**G02B 26/08** (2006.01)

(52) Cooperative Patent Classification (CPC):
**B81B 3/00; G02B 26/08; G02B 26/10**

(86) International application number:
**PCT/JP2022/033041**

(87) International publication number:
**WO 2023/053840 (06.04.2023 Gazette 2023/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.09.2021 JP 2021158222**

(71) Applicant: **FUJIFILM Corporation
Tokyo 106-8620 (JP)**

(72) Inventors:
• **NISHIURA, Yosuke
  Ashigarakami-gun, Kanagawa 258-8577 (JP)**
• **NAKABAYASHI, Koki
  Ashigarakami-gun, Kanagawa 258-8577 (JP)**

(74) Representative: **HGF
HGF Limited
1 City Walk
Leeds LS11 9DX (GB)**

(54) **OPTICAL SCANNING DEVICE**

(57) The optical scanning device includes: a micromirror device including a mirror portion that has a reflecting surface for reflecting incident light, a first actuator that allows the mirror portion to swing around a first axis parallel to the reflecting surface in a case where the mirror portion is stationary, and a second actuator that allows the mirror portion to swing around a second axis parallel to the reflecting surface and orthogonal to the first axis; a light source that emits a light beam; a light deflector that deflects the light beam emitted from the light source; an optical system that guides the light beam deflected by the light deflector to a back surface of the mirror portion, which is a surface opposite to the reflecting surface; and a position detector that detects a position of the light beam deflected by the back surface.

FIG. 12

**Description**

BACKGROUND OF THE INVENTION

1. Field of the Invention

The technology of the present disclosure relates to an optical scanning device.

2. Description of the Related Art

A micromirror device (also referred to as a microscanner) is known as one of micro electro mechanical systems (MEMS) devices manufactured using the silicon (Si) microfabrication technique. The micromirror device is driven by a driving control unit provided in an optical scanning device. By driving a mirror portion of the micromirror device, the driving control unit two-dimensionally scans an object with a light beam reflected by the mirror portion.

An optical scanning method using the micromirror device is superior to an optical scanning method using a polygon mirror in the related art in terms of small size, light weight, and low power consumption. Therefore, application of the micromirror device to a light detection and ranging (LiDAR) device, a scanning beam display, and the like is attracting attention.

In such an optical scanning device, the light beam is deflected by changing an angle of the mirror portion. Therefore, in order to ascertain a scanning position of the light beam in the object, it is necessary to detect the angle of the mirror portion. A method is known in which a strain sensor is provided in the vicinity of the mirror portion and the angle of the mirror portion is calculated based on an output value of the strain sensor. However, since the strain sensor detects a change in physical properties of a material, detection sensitivity has temperature dependence and changes due to deterioration of the material. Therefore, an accuracy of angle detection of the mirror portion by the strain sensor is low.

JP2012-198511A discloses a method of estimating a rotation angle of a mirror portion by using a light beam. Specifically, JP2012-198511A proposes a method of estimating the rotation angle of the mirror portion by irradiating a back surface of the mirror portion with a light beam and detecting the reflected light with a position detector.

SUMMARY OF THE INVENTION

However, in the apparatus disclosed in JP2012-198511A, a beam splitter is used to make a light beam emitted from a light source incident on the back surface of the mirror portion from below and to guide the light beam reflected from the back surface of the mirror portion to the position detector. As described above, in the apparatus disclosed in JP2012-198511A, the light beam emitted from the light source is dimmed twice by the beam splitter before it is incident into the position detector, so that the light efficiency is poor. In addition, in a case where the beam splitter is used, optical noise such as stray light is generated, so that it is necessary to sufficiently take measures against noise.

In order to solve the above problem, it is considered that a light beam is made incident on the back surface of the mirror portion from an oblique direction without using the beam splitter. However, in a case where the light beam is made incident on the back surface of the mirror portion from the oblique direction, an image due to the light beam reflected from the back surface of the mirror portion is distorted, so that data processing by the position detector is difficult.

An object of the technology of the present disclosure is to provide an optical scanning device capable of improving an efficiency and accuracy of angle detection of a mirror portion.

In order to achieve the above object, an optical scanning device of the present disclosure comprises: a micromirror device including a mirror portion that has a reflecting surface for reflecting incident light, a first actuator that allows the mirror portion to swing around a first axis parallel to the reflecting surface in a case where the mirror portion is stationary, and a second actuator that allows the mirror portion to swing around a second axis parallel to the reflecting surface and orthogonal to the first axis; a light source that emits a light beam; a light deflector that deflects the light beam emitted from the light source; an optical system that guides the light beam deflected by the light deflector to a back surface of the mirror portion, which is a surface opposite to the reflecting surface; and a position detector that detects a position of the light beam deflected by the back surface.

It is preferable that the optical scanning device further comprises a processor that causes the mirror portion to perform precession or spiral motion by providing a first driving signal and a second driving signal having the same driving frequency to the first actuator and the second actuator, respectively.

It is preferable that the light deflector has a surface mirror formed by depositing a metal thin film or a dielectric multi-layer film on a surface of a base material, and that the light deflector deflects the light beam emitted from the light source by reflecting the light beam by the surface mirror.

It is preferable that the base material is a cylinder, and that the surface mirror is formed on a cut surface formed by cutting the base material obliquely with respect to a rotational symmetry axis of the cylinder.

It is preferable that the first actuator and the second actuator are piezoelectric actuators each including a piezoelectric element.

It is preferable that the light beam deflected by the back surface is incident into the optical system, and that the optical system guides the incident light beam to a light-receiving surface of the position detector.

It is preferable that the optical system always makes the incident light beam be incident on the light-receiving surface.

It is preferable that a beam diameter of the light beam on the back surface is larger than a beam diameter of the light beam on the light-receiving surface.

It is preferable that an elliptical structure is formed on the back surface, that the light beam is incident into an inner region of the structure, and that a beam diameter of the light beam on the back surface is smaller than an inner diameter of the structure in a minor axis direction.

It is preferable that the position detector is a sensor that detects a light quantity centroid position of the light beam.

According to the technology of the present disclosure, it is possible to provide an optical scanning device capable of improving an efficiency and accuracy of angle detection of a mirror portion.

BRIEF DESCRIPTION OF THE DRAWINGS

Fig. 1 is a schematic view of an optical scanning device.
Fig. 2 is a block diagram showing an example of a hardware configuration of a driving control unit.
Fig. 3 is an external perspective view of a micromirror device.
Fig. 4 is a plan view of the micromirror device as viewed from the light incident side.
Fig. 5 is a cross-sectional view taken along the line A-A of Fig. 4.
Fig. 6 is a cross-sectional view taken along the line B-B of Fig. 4.
Fig. 7 is a diagram showing an example in which a first actuator is driven in an anti-phase resonance mode.
Fig. 8 is a diagram showing an example in which a second actuator is driven in an anti-phase resonance mode.
Fig. 9 is a diagram showing an example of a driving signal provided to the first actuator and the second actuator.
Fig. 10 is a diagram illustrating a time change of a maximum deflection angle.
Fig. 11 is a diagram illustrating precession of a mirror portion.
Fig. 12 is a diagram showing an example of a configuration of an angle detection unit.
Fig. 13 is a schematic perspective view of a position detector and a light deflector.
Fig. 14 is a diagram showing an example of a trajectory of a light beam incident on a light-receiving surface of the position detector.
Fig. 15 is a schematic view of an optical scanning device according to a modification example.
Fig. 16 is a diagram showing a modification example of the trajectory of the light beam incident on the light-receiving surface of the position detector.
Fig. 17 is a diagram showing an example of a configuration on a back surface side of the micromirror device.
Fig. 18 is a diagram showing a relationship between a size of a structure and a beam diameter of a light beam.
Fig. 19 is a diagram illustrating a light deflector according to a first modification example.
Fig. 20 is a diagram illustrating the light deflector according to the first modification example.

DESCRIPTION OF THE PREFERRED EMBODIMENTS

An example of an embodiment according to the technology of the present disclosure will be described with reference to the accompanying drawings.

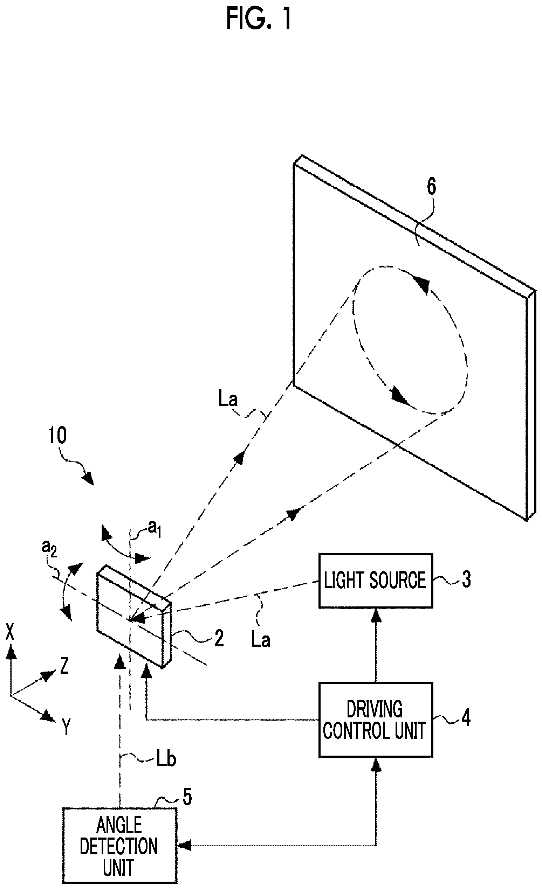

Fig. 1 schematically shows an optical scanning device 10 according to an embodiment. The optical scanning device 10 includes a micromirror device (hereinafter, referred to as micromirror device (MMD)) 2, a light source 3, a driving control unit 4, and an angle detection unit 5. The optical scanning device 10 optically scans a surface to be scanned 6 by reflecting a light beam La emitted from the light source 3 with the MMD 2 under the control of the driving control unit 4. The surface to be scanned 6 is, for example, a screen.

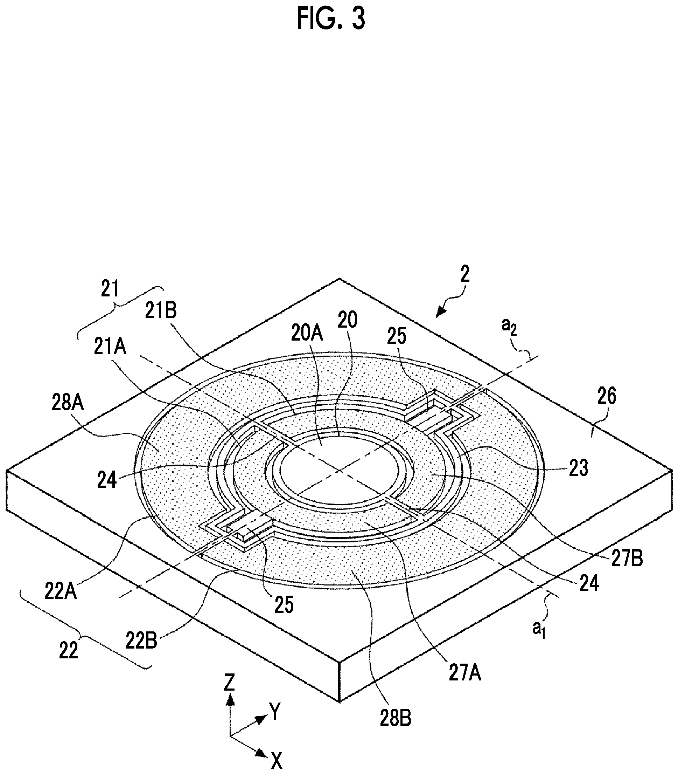

The MMD 2 is a piezoelectric biaxial drive-type micromirror device capable of allowing a mirror portion 20 (see Fig. 3) to swing around a first axis $a_1$ and a second axis $a_2$ orthogonal to the first axis $a_1$. Hereinafter, the direction parallel to the first axis $a_1$ is referred to as an X direction, the direction parallel to the second axis $a_2$ is a Y direction, and the direction orthogonal to the first axis $a_1$ and the second axis $a_2$ is referred to as a Z direction.

The light source 3 is a laser device that emits, for example, laser light as the light beam La. It is preferable that the light source 3 emits the light beam La perpendicularly to a reflecting surface 20A (see Fig. 3) included in the mirror portion 20 in a state where the mirror portion 20 of the MMD 2 is stationary.

The driving control unit 4 outputs a driving signal to the light source 3 and the MMD 2 based on optical scanning information. The light source 3 generates the light beam La based on the input driving signal and emits the light beam La to the MMD 2. The MMD 2 allows the mirror portion 20 to swing around the first axis $a_1$ and the second axis $a_2$ based on the input driving signal.

As will be described in detail below, in the present embodiment, the driving control unit 4 causes the mirror portion 20 to perform precession. By the precession of the mirror portion 20, the surface to be scanned 6 is scanned with the light beam La reflected by the mirror portion 20 such that a circle is drawn on the surface to be scanned 6. The circular light beam La is used, for example, in the LiDAR device.

As will be described in detail below, the angle detection unit 5 irradiates a back surface side of the mirror portion 20 (that is, a side opposite to a surface on which the light beam La is emitted) with a light beam Lb for angle detection, thereby detecting an angle of the mirror portion 20. The detection operation of the angle detection unit 5 is controlled by the driving control unit 4. For example, the driving control unit 4 performs feedback control such that the precession of the mirror portion 20 is maintained, based on an angle detection signal output from the angle detection unit 5.

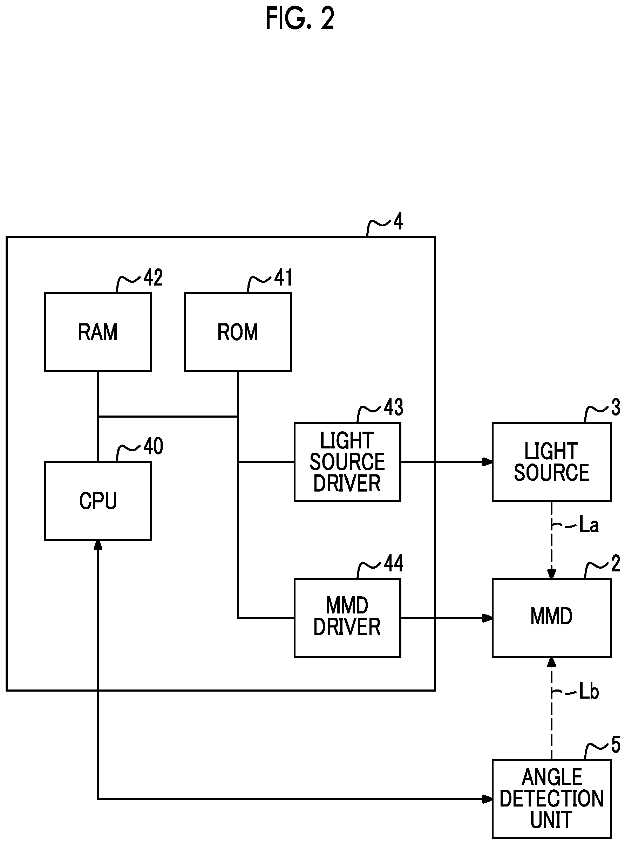

Fig. 2 shows an example of a hardware configuration of the driving control unit 4. The driving control unit 4 has a central processing unit (CPU) 40, a read only memory (ROM) 41, a random access memory (RAM) 42, a light source driver 43, and an MMD driver 44. The CPU 40 is an arithmetic unit that realizes the entire function of the driving control unit 4 by reading out a program and data from a storage device such as the ROM 41 into the RAM 42 and executing processing. The CPU 40 is an example of a "processor" according to the technology of the present disclosure.

The ROM 41 is a non-volatile storage device and stores a program for the CPU 40 to execute processing and data such as the optical scanning information described above. The RAM 42 is a non-volatile storage device that temporarily holds a program and data.

The light source driver 43 is an electric circuit that outputs a driving signal to the light source 3 under the control of the CPU 40. In the light source driver 43, the driving signal is a driving voltage for controlling the irradiation timing and the irradiation intensity of the light source 3.

The MMD driver 44 is an electric circuit that outputs a driving signal to the MMD 2 under the control of the CPU 40. In the MMD driver 44, the driving signal is a driving voltage for controlling the timing, cycle, and deflection angle for allowing the mirror portion 20 of the MMD 2 to swing.

The CPU 40 controls the light source driver 43 and the MMD driver 44 based on the optical scanning information. The optical scanning information is information for indicating how the surface to be scanned 6 is scanned with the light beam La. In the present embodiment, the optical scanning information is information for indicating that the surface to be scanned 6 is scanned with the light beam La such that a circle is drawn on the surface to be scanned 6. For example, in a case where the optical scanning device 10 is incorporated in the LiDAR device, the optical scanning information includes a time at which the light beam La for distance measurement is emitted, an irradiation range, and the like.

The CPU 40 controls the detection operation of the angle detection unit 5, and controls the MMD driver 44 such that the precession of the mirror portion 20 is maintained, based on the angle detection signal output from the angle detection unit 5.

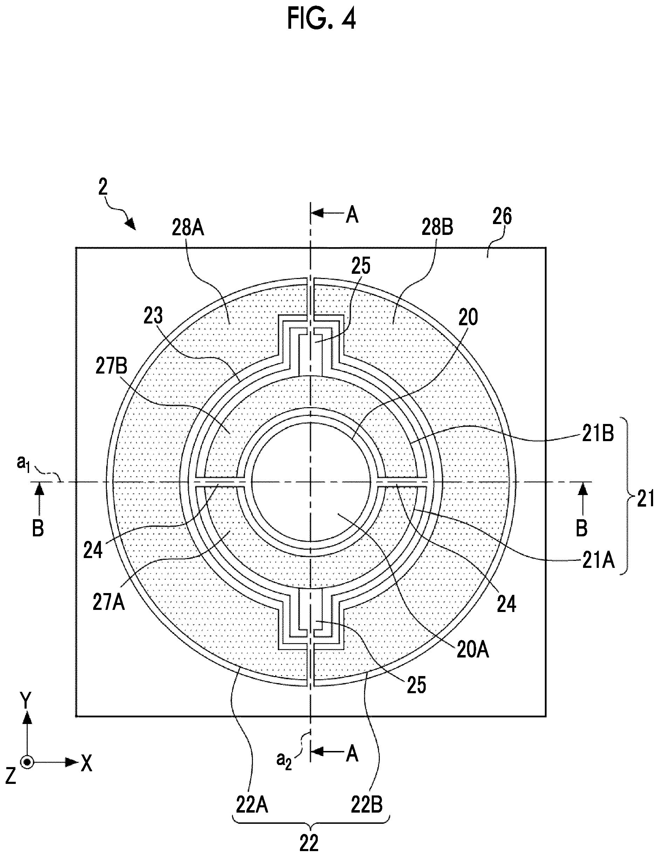

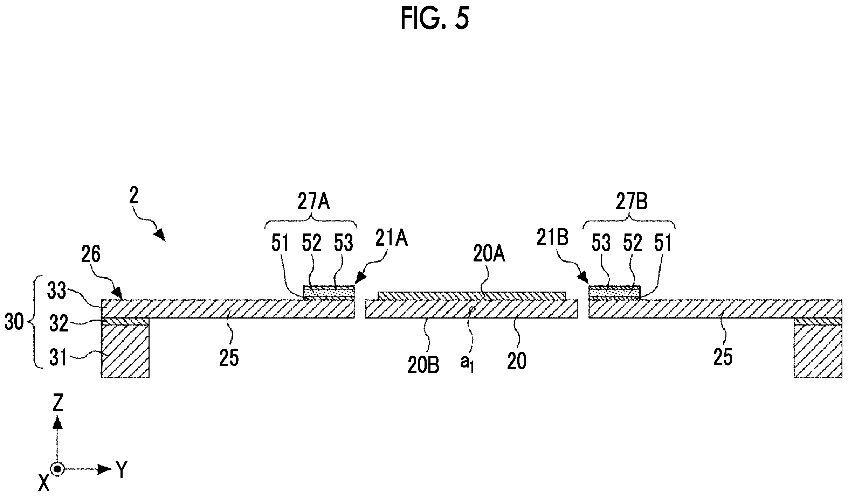

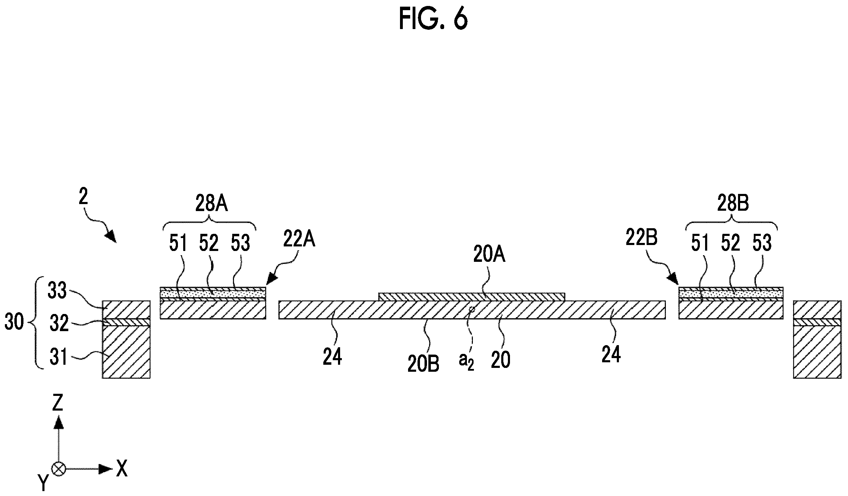

Next, an example of the MMD 2 will be described with reference to Figs. 3 to 6. Fig. 3 is an external perspective view of the MMD 2. Fig. 4 is a plan view of the MMD 2 as viewed from the light incident side. Fig. 5 is a cross-sectional view taken along the line A-A in Fig. 4. Fig. 6 is a cross-sectional view taken along the line B-B in Fig. 4.

As shown in Figs. 3 and 4, the MMD 2 has a mirror portion 20, a first actuator 21, a second actuator 22, a support frame 23, a first support portion 24, a second support portion 25, and a fixed portion 26. The MMD 2 is a so-called MEMS device.

The mirror portion 20 has a reflecting surface 20A for reflecting incident light. The reflecting surface 20A is formed of a metal thin film such as gold (Au) and aluminum (Al) provided on one surface of the mirror portion 20. The reflecting surface 20A is, for example, circular.

The first actuator 21 is disposed to surround the mirror portion 20. The support frame 23 is disposed to surround the mirror portion 20 and the first actuator 21. The second actuator 22 is disposed to surround the mirror portion 20, the first actuator 21, and the support frame 23. The support frame 23 is not an essential component of the technology of the present disclosure.

The first support portion 24 connects the mirror portion 20 and the first actuator 21 on the first axis $a_1$, and swingably supports the mirror portion 20 around the first axis $a_1$. The first axis $a_1$ is parallel to the reflecting surface 20A in a case where the mirror portion 20 is stationary. For example, the first support portion 24 is a torsion bar stretched along the first axis $a_1$. In addition, the first support portion 24 is connected to the support frame 23 on the first axis $a_1$.

The second support portion 25 connects the first actuator 21 and the second actuator 22 on the second axis $a_2$, and swingably supports the mirror portion 20 and the first actuator 21 around the second axis $a_2$. The second axis $a_2$ is parallel to the reflecting surface 20A in a case where the mirror portion 20 is stationary and is orthogonal to the first axis $a_1$. The second support portion 25 is connected to the support frame 23 and the fixed portion 26 on the second axis $a_2$.

The fixed portion 26 is connected to the second actuator 22 by the second support portion 25. The fixed portion 26 has a rectangular outer shape and surrounds the second actuator 22. Lengths of the fixed portion 26 in the X direction and the Y direction are, for example, about 1 mm to 10 mm, respectively. A thickness of the fixed portion 26 in the Z direction is, for example, about 5 μm to 0.2 mm.

The first actuator 21 and the second actuator 22 are piezoelectric actuators each comprising a piezoelectric element. The first actuator 21 applies rotational torque around the first axis $a_1$ to the mirror portion 20. The second actuator 22 applies rotational torque around the second axis $a_2$ to the mirror portion 20 and the first actuator 21. Thereby, the mirror portion 20 swings around the first axis $a_1$ and the second axis $a_2$.

The first actuator 21 is an annular thin plate member that surrounds the mirror portion 20 in an XY plane. The first actuator 21 is composed of a pair of a first movable portion 21A and a second movable portion 21B. Each of the first movable portion 21A and the second movable portion 21B is semi-annular. The first movable portion 21A and the second movable portion 21B have a shape that is line-symmetrical with respect to the first axis $a_1$, and are connected on the first axis $a_1$.

The support frame 23 is an annular thin plate member that surrounds the mirror portion 20 and the first actuator 21 in the XY plane.

The second actuator 22 is an annular thin plate member that surrounds the mirror portion 20, the first actuator 21, and the support frame 23 in the XY plane. The second actuator 22 is composed of a pair of a first movable portion 22A and a second movable portion 22B. Each of the first movable portion 22A and the second movable portion 22B is semi-annular. The first movable portion 22A and the second movable portion 22B have a shape that is line-symmetrical with respect to the second axis $a_2$, and are connected on the second axis $a_2$.

In the first actuator 21, the first movable portion 21A and the second movable portion 21B are provided with a piezoelectric element 27A and a piezoelectric element 27B, respectively. In addition, in the second actuator 22, the first movable portion 22A and the second movable portion 22B are provided with a piezoelectric element 28A and a piezoelectric element 28B, respectively.

In Figs. 3 and 4, a wiring line and an electrode pad for providing the driving signal to the piezoelectric elements 27A, 27B, 28A, and 28B are not shown. A plurality of the electrode pads are provided on the fixed portion 26.

As shown in Figs. 5 and 6, the MMD 2 is formed, for example, by performing an etching treatment on a silicon on insulator (SOI) substrate 30. The SOI substrate 30 is a substrate in which a silicon oxide layer 32 is provided on a first silicon active layer 31 made of single crystal silicon, and a second silicon active layer 33 made of single crystal silicon is provided on the silicon oxide layer 32.

The mirror portion 20, the first actuator 21, the second actuator 22, the support frame 23, the first support portion 24, and the second support portion 25 are formed of the second silicon active layer 33 remaining by removing the first silicon active layer 31 and the silicon oxide layer 32 from the SOI substrate 30 with an etching treatment. The second silicon active layer 33 functions as an elastic portion having elasticity. The fixed portion 26 is formed of three layers of the first silicon active layer 31, the silicon oxide layer 32, and the second silicon active layer 33.

The piezoelectric elements 27A, 27B, 28A, and 28B have a laminated structure in which a lower electrode 51, a piezoelectric film 52, and an upper electrode 53 are sequentially laminated on the second silicon active layer 33. An insulating film is provided on the upper electrode 53, but is not shown.

The upper electrode 53 and the lower electrode 51 are formed of, for example, gold (Au) or platinum (Pt). The piezoelectric film 52 is formed of, for example, lead zirconate titanate (PZT), which is a piezoelectric material. The upper electrode 53 and the lower electrode 51 are electrically connected to the driving control unit 4 described above via the wiring line and the electrode pad.

A driving voltage is applied to the upper electrode 53 from the driving control unit 4. The lower electrode 51 is connected to the driving control unit 4 via the wiring line and the electrode pad, and a reference potential (for example, a ground potential) is applied thereto.

In a case where a positive or negative voltage is applied to the piezoelectric film 52 in the polarization direction, deformation (for example, expansion and contraction) proportional to the applied voltage occurs. That is, the piezoelectric film 52 exerts a so-called inverse piezoelectric effect. The piezoelectric film 52 exerts an inverse piezoelectric effect by applying a driving voltage from the driving control unit 4 to the upper electrode 53, and displaces the first actuator 21 and the second actuator 22.

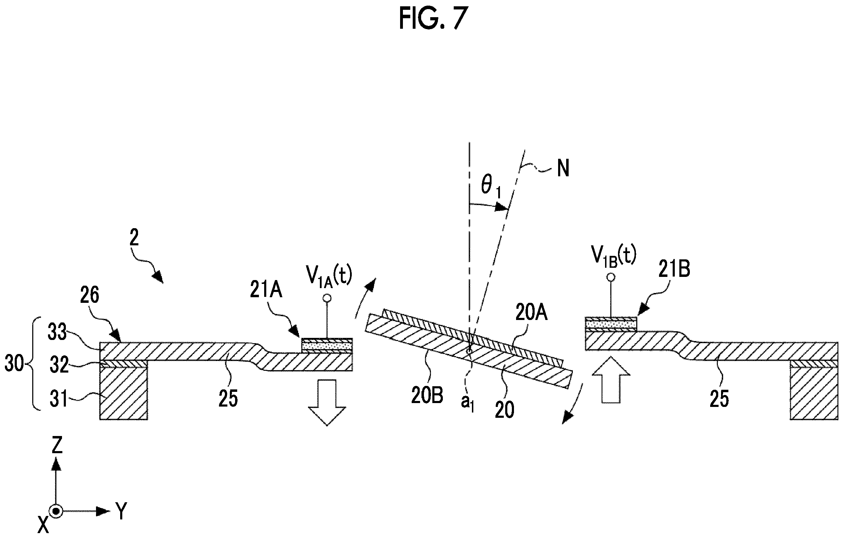

Fig. 7 shows a state in which the first actuator 21 is driven by extending one of the piezoelectric films 52 of the first movable portion 21A and the second movable portion 21B and contracting the other piezoelectric film 52. In this way, the first movable portion 21A and the second movable portion 21B are displaced in opposite directions to each other, whereby the mirror portion 20 rotates around the first axis $a_1$.

Fig. 7 shows an example in which the first actuator 21 is driven in an anti-phase resonance mode in which the displacement direction of the first movable portion 21A and the second movable portion 21B and the rotation direction of the mirror portion 20 are opposite to each other. In Fig. 7, the first movable portion 21A is displaced in the -Z direction and the second movable portion 21B is displaced in the +Z direction, so that the mirror portion 20 rotates in the +Y direction. The first actuator 21 may be driven in an in-phase resonance mode in which the displacement direction of the first movable portion 21A and the second movable portion 21B and the rotation direction of the mirror portion 20 are the same direction.

An angle at which a normal line N of the reflecting surface 20A of the mirror portion 20 is inclined in the YZ plane is called a first deflection angle $\theta_1$. In a case where the normal line N of the reflecting surface 20A is inclined in the +Y direction, the first deflection angle $\theta_1$ takes a positive value, and in a case where it is inclined in the -Y direction, the first deflection angle $\theta_1$ takes a negative value.

The first deflection angle $\theta_1$ is controlled by the driving signal (hereinafter, referred to as a first driving signal) provided to the first actuator 21 by the driving control unit 4. The first driving signal is, for example, a sinusoidal AC voltage. The first driving signal includes a driving voltage waveform $V_{1A}$ (t) applied to the first movable portion 21A and a driving voltage waveform $V_{1B}$ (t) applied to the second movable portion 21B. The driving voltage waveform $V_{1A}$ (t) and the driving voltage waveform $V_{1B}$ (t) are in an anti-phase with each other (that is, the phase difference is 180°).

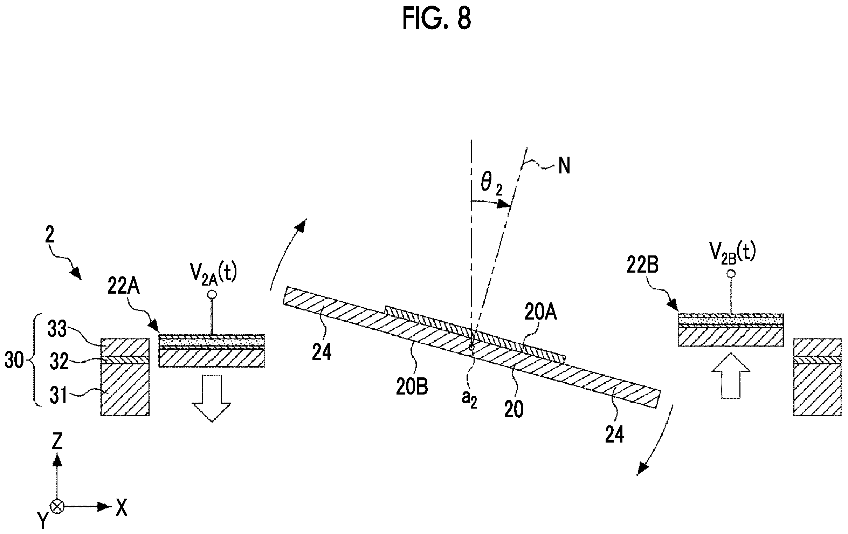

Fig. 8 shows an example in which the second actuator 22 is driven in an anti-phase resonance mode in which the displacement direction of the first movable portion 22A and the second movable portion 22B and the rotation direction of the mirror portion 20 are opposite to each other. In Fig. 8, the first movable portion 22A is displaced in the -Z direction and the second movable portion 22B is displaced in the +Z direction, so that the mirror portion 20 rotates in the +X direction. The second actuator 22 may be driven in an in-phase resonance mode in which the displacement direction of the first movable portion 22A and the second movable portion 22B and the rotation direction of the mirror portion 20 are the same direction.

An angle at which the normal line N of the reflecting surface 20A of the mirror portion 20 is inclined in the XZ plane is called a second deflection angle $\theta_2$. In a case where the normal line N of the reflecting surface 20A is inclined in the +X direction, the second deflection angle $\theta_2$ takes a positive value, and in a case where it is inclined in the -X direction, the second deflection angle $\theta_2$ takes a negative value.

The second deflection angle $\theta_2$ is controlled by the driving signal (hereinafter, referred to as a second driving signal) provided to the second actuator 22 by the driving control unit 4. The second driving signal is, for example, a sinusoidal AC voltage. The second driving signal includes a driving voltage waveform $V_{2A}$ (t) applied to the first movable portion 22A and a driving voltage waveform $V_{2B}$ (t) applied to the second movable portion 22B. The driving voltage waveform $V_{2A}$ (t) and the driving voltage waveform $V_{2B}$ (t) are in an anti-phase with each other (that is, the phase difference is 180°).

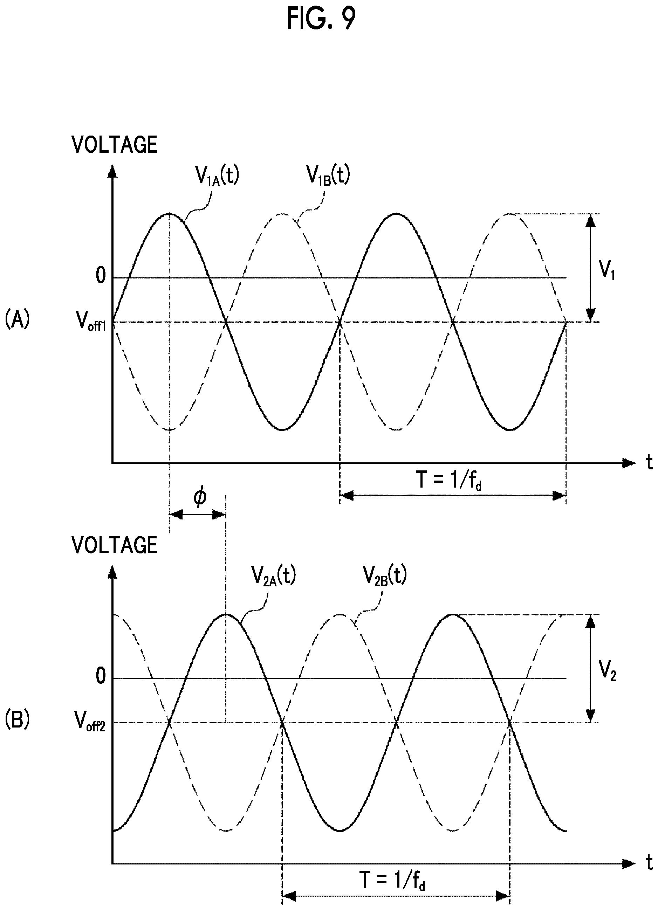

Fig. 9 shows an example of a driving signal provided to the first actuator 21 and the second actuator 22. (A) of Fig. 9 shows the driving voltage waveforms $V_{1A}$ (t) and $V_{1B}$ (t) included in the first driving signal. (B) of Fig. 9 shows the driving voltage waveforms $V_{2A}$ (t) and $V_{2B}$ (t) included in the second driving signal.

The driving voltage waveforms $V_{1A}$ (t) and $V_{1B}$ (t) are represented as follows, respectively.

$$V_{1A} (t) = V_{off1} + V_1 sin(2\pi f_d t)$$

$$V_{1B} (t) = V_{off1} + V_1 sin(2\pi f_d t + \alpha)$$

Here, $V_1$ is the amplitude voltage. $V_{off1}$ is the bias voltage. $f_d$ is the driving frequency. t is time. $\alpha$ is the phase difference between the driving voltage waveforms $V_{1A}$ (t) and $V_{1B}$ (t). In the present embodiment, for exam-

ple, $\alpha$ = 180°.

By applying the driving voltage waveforms $V_{1A}$ (t) and $V_{1B}$ (t) to the first movable portion 21A and the second movable portion 21B, the mirror portion 20 swings around the first axis $a_1$ (see Fig. 7).

The driving voltage waveforms $V_{2A}$ (t) and $V_{2B}$ (t) are represented as follows, respectively.

$$V_{2A} (t) = V_{off2} + V_2 sin(2\pi f_d t + \varphi)$$

$$V_{2B} (t) = V_{off2} + V_2 sin(2\pi f_d t + \beta + \varphi)$$

Here, $V_2$ is the amplitude voltage. $V_{off2}$ is the bias voltage. $f_d$ is the driving frequency. t is time. $\beta$ is the phase difference between the driving voltage waveforms $V_{2A}$ (t) and $V_{2B}$ (t). In the present embodiment, for example, $\beta$ = 180°. In addition, $\varphi$ is the phase difference between the driving voltage waveforms $V_{1A}$ (t) and $V_{1B}$ (t) and the driving voltage waveforms $V_{2A}$ (t) and $V_{2B}$ (t). In the present embodiment, $\varphi$ = 90° is set in order to cause the mirror portion 20 to perform precession.

The bias voltages $V_{off1}$ and $V_{off2}$ are DC voltages for determining a state where the mirror portion 20 is stationary. In a state where the mirror portion 20 is stationary, a plane including the reflecting surface 20A may not be parallel to an upper surface of the fixed portion 26 and may be inclined with respect to the upper surface of the fixed portion 26.

By applying the driving voltage waveforms $V_{2A}$ (t) and $V_{2B}$ (t) to the first movable portion 22A and the second movable portion 22B, the mirror portion 20 swings around the second axis $a_2$ (see Fig. 8).

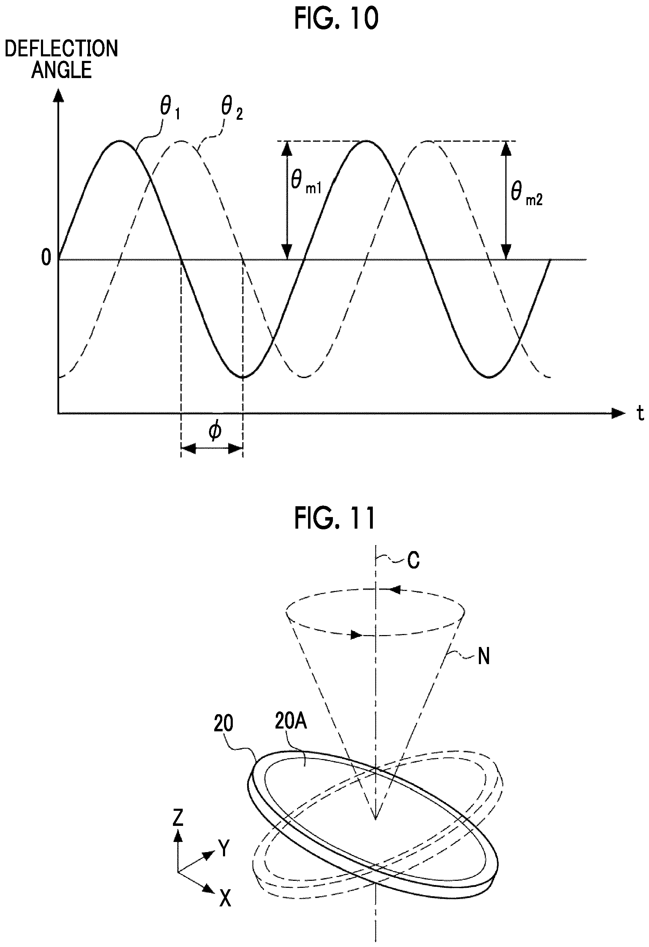

As described above, the first driving signal and the second driving signal have the same driving frequency $f_d$ and a phase difference of 90°. In order to cause the mirror portion 20 to perform precession, as shown in Fig. 10, it is necessary to set the amplitude voltages Vi and $V_2$ appropriately such that the maximum deflection angle $\theta_{m1}$ of the first deflection angle $\theta_1$ matches the maximum deflection angle $\theta_{m2}$ of the second deflection angle $\theta_2$. This is because a relationship between the amplitude voltage $V_1$ and the first deflection angle $\theta_1$ and a relationship between the amplitude voltage $V_2$ and the second deflection angle $\theta_2$ are not the same. In the description of the present specification, the meaning of "match" includes not only the meaning of perfect match but also the meaning of substantial match including allowable errors in design and manufacturing.

In order to cause the mirror portion 20 to perform the precession with high accuracy, it is necessary to appropriately set the driving frequency $f_d$. Fig. 11 shows the precession of the mirror portion 20. The precession is a motion in which the normal line N of the reflecting surface 20A of the mirror portion 20 is deflected such that a circle is drawn about a rotation axis C parallel to the Z direction. By irradiating the mirror portion 20 that performs the precession with the light beam La from the light source 3, the surface to be scanned 6 can be scanned with the light beam La such that a circle is drawn on the surface to be scanned 6.

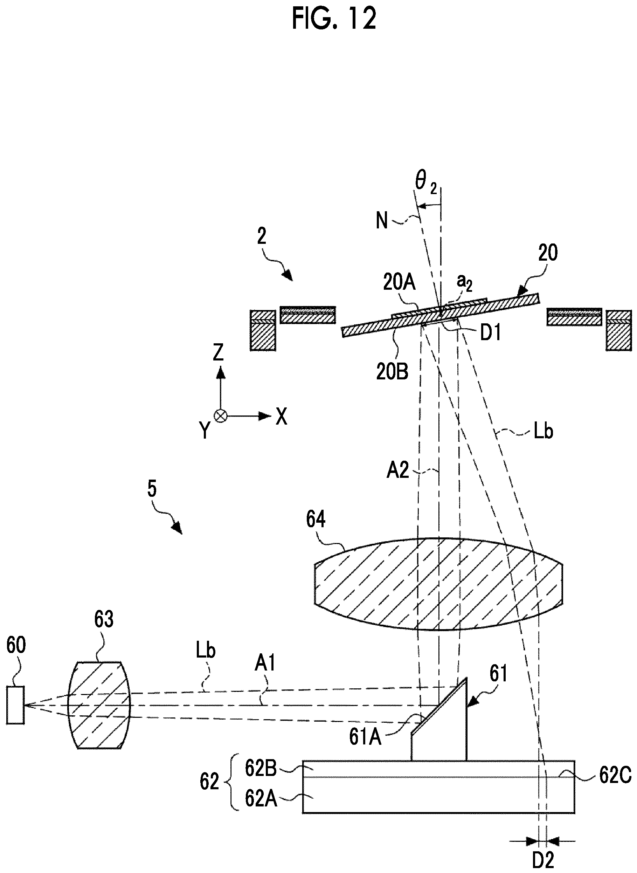

Fig. 12 shows an example of a configuration of the angle detection unit 5. As shown in Fig. 12, the angle detection unit 5 comprises a light source 60, a light deflector 61, a position detector 62, a first optical system 63, and a second optical system 64. The light source 60 emits the light beam Lb for angle detection. For example, the light source 60 is a laser diode that emits laser light having a wavelength of about 980 nm as the light beam Lb.

The light deflector 61 has a cut surface formed by cutting a base material of a cylinder obliquely with respect to a rotational symmetry axis of the cylinder, and a reflecting surface 61A is formed on the cut surface. Specifically, the light deflector 61 has a cut surface formed by cutting the base material of the cylinder in a plane forming an angle of 45° with respect to the rotational symmetry axis of the cylinder. For example, the reflecting surface 61A is a surface mirror formed by depositing a metal thin film, such as gold (Au), aluminum (Al), or silver (Au), on the cut surface. In addition, the reflecting surface 61A may be a surface mirror formed by depositing a dielectric multi-layer film on the cut surface.

The light deflector 61 is disposed such that the light beam Lb emitted from the light source 60 is incident at an incidence angle of about 45°. The light deflector 61 is an optical deflector that deflects the light beam Lb.

The first optical system 63 is provided on an optical path of the light beam Lb between the light source 60 and the light deflector 61. The first optical system 63 condenses the light beam Lb emitted from the light source 60 and guides the condensed light beam to the reflecting surface 61A of the light deflector 61. The first optical system 63 is, for example, a biconvex lens, and is disposed such that an optical axis A1 thereof passes through the center of the optical path of the light beam Lb. In the present embodiment, the optical axis A1 is parallel to the X direction. An angle of the light beam Lb incident on the reflecting surface 61A is deflected by 90° and travels in the Z direction. That is, the light deflector 61 deflects the light beam Lb by 90°.

In the present embodiment, although all of the light beams Lb emitted from the light source 60 are condensed by the first optical system 63 and guided to the reflecting surface 61A of the light deflector 61, at least a part of the light beams Lb emitted from the light source 60 need only be guided to the reflecting surface 61A. In addition, the first optical system 63 is not an essential configuration in the technology of the present disclosure.

The MMD 2 is disposed such that the light beam Lb deflected by the light deflector 61 is incident on a back surface 20B of the mirror portion 20. The back surface 20B is a surface opposite to the surface of the mirror portion 20 on which the reflecting surface 20A is formed.

The back surface 20B of the mirror portion 20 is a surface that reflects the light beam Lb (that is, it is not a light absorption surface).

The second optical system 64 is provided on an optical path of the light beam Lb between the light deflector 61 and the MMD 2. The second optical system 64 condenses the light beam Lb deflected by the light deflector 61 and guides the condensed light beam to the back surface 20B of the mirror portion 20. The second optical system 64 is, for example, a biconvex lens, and is disposed such that an optical axis A2 thereof passes through the center of the optical path of the light beam Lb reflected from the reflecting surface 61A. In the present embodiment, the optical axis A2 is parallel to the Z direction. The second optical system 64 is an example of an "optical system" according to the technology of the present disclosure.

In the present embodiment, although all of the light beams Lb deflected by the light deflector 61 are condensed by the second optical system 64 and guided to the back surface 20B of the mirror portion 20, at least a part of the light beams Lb deflected by the light deflector 61 need only be guided to the back surface 20B.

The light beam Lb incident on the back surface 20B of the mirror portion 20 is reflected at a reflection angle corresponding to the deflection angle (first deflection angle $\theta_1$ and second deflection angle $\theta_2$) of the mirror portion 20. That is, the back surface 20B of the mirror portion 20 deflects the incident light beam Lb. The light beam Lb deflected by the back surface 20B of the mirror portion 20 is incident into the second optical system 64, and is guided to a light-receiving surface 62C of the position detector 62 by the second optical system 64. The second optical system 64 is configured such that the light beam Lb deflected by the back surface 20B of the mirror portion 20 is always incident on the light-receiving surface 62C of the position detector 62.

In a case where the mirror portion 20 performs precession, the light beam Lb deflected by the back surface 20B of the mirror portion 20 is incident into a peripheral edge portion of the second optical system 64. The second optical system 64 condenses the incident light beam Lb and causes the condensed light beam to be incident into the position detector 62. As described above, since the second optical system 64 has a condensing effect, a beam diameter D1 of the light beam Lb on the back surface 20B of the mirror portion 20 is larger than a beam diameter D2 of the light beam Lb on the light-receiving surface 62C of the position detector 62. That is, a relationship of D1 > D2 is satisfied.

The position detector 62 includes a two-dimensional position sensitive detector (PSD) element 62A and a protective glass 62B disposed on the light-receiving surface 62C of the two-dimensional PSD element 62A. The position detector 62 is disposed such that the optical axis A2 of the second optical system 64 is orthogonal to the light-receiving surface 62C. The above-described light deflector 61 is disposed on the protective glass 62B in the center of the position detector 62. That is, a bottom surface of the light deflector 61 is joined to a surface of the protective glass 62B.

The two-dimensional PSD element 62A detects the position of the light beam Lb incident on the light-receiving surface 62C. Specifically, the two-dimensional PSD element 62A is a sensor capable of detecting a light quantity centroid position of a spot of the light beam Lb incident on the light-receiving surface 62C, and detects two-dimensional coordinates of the light quantity centroid position. The two-dimensional coordinates of the light quantity centroid position of the light beam Lb correspond to the deflection angles (first deflection angle $\theta_1$ and second deflection angle $\theta_2$) of the mirror portion 20. The position detector 62 outputs the detected two-dimensional coordinates to the driving control unit 4 as the above-described angle detection signal.

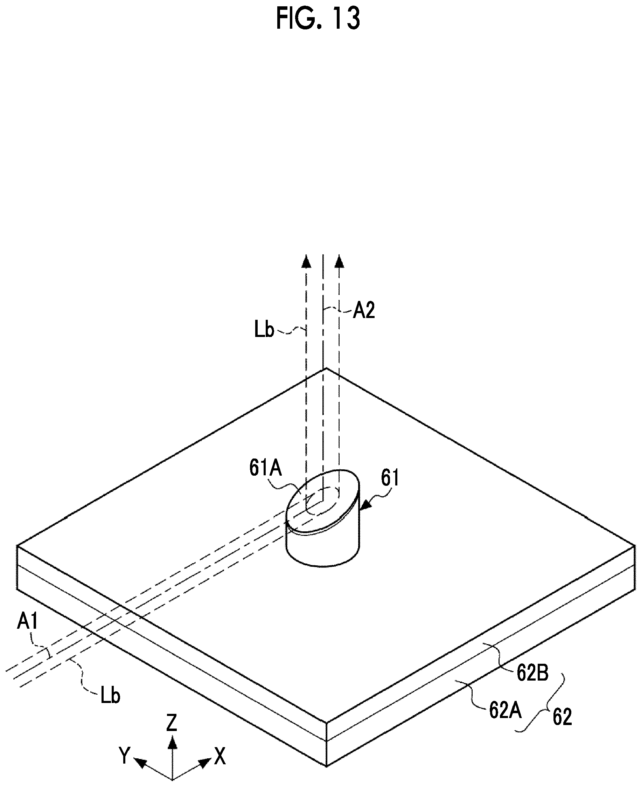

Fig. 13 is a schematic perspective view of the position detector 62 and the light deflector 61. As shown in Fig. 13, the two-dimensional PSD element 62A and the protective glass 62B constituting the position detector 62 each have a flat plate shape and a rectangular outer shape.

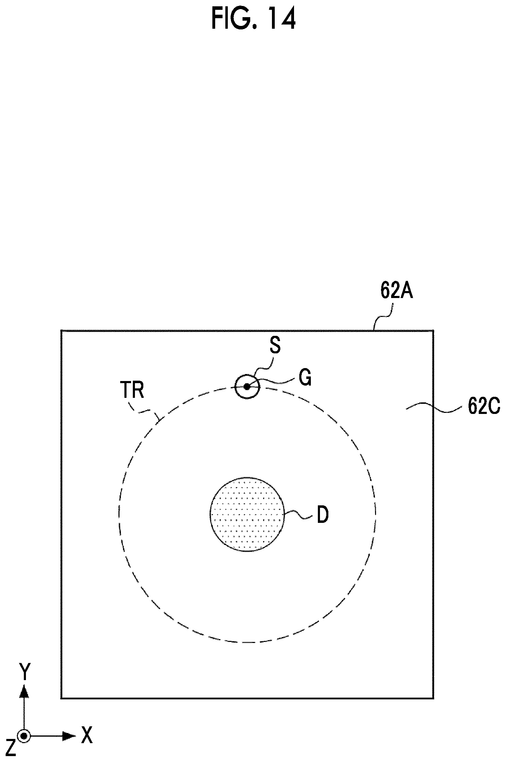

Fig. 14 shows an example of a trajectory of the light beam Lb incident on the light-receiving surface 62C of the position detector 62. In Fig. 14, S indicates a spot of the light beam Lb. G indicates the light quantity centroid position of the light quantity of the spot S. TR indicates the trajectory of the light quantity centroid position. D indicates a shadow of the light deflector 61 reflected on the light-receiving surface 62C.

In a case where the mirror portion 20 performs the precession, the trajectory TR is substantially circular. Since the light deflector 61 is disposed in the center of the position detector 62, the trajectory TR orbits around the shadow D of the light deflector 61 and does not intersect the shadow D. Therefore, the position detector 62 accurately detects the two-dimensional coordinates of the light beam Lb incident on the light-receiving surface 62C.

As described above, according to the technology of the present disclosure, by using the light deflector 61, the light beam Lb can be made incident on the back surface 20B of the mirror portion 20 without using a beam splitter, and the light beam Lb deflected by the back surface 20B can be detected without being blocked by the light deflector 61. As a result, the efficiency and accuracy of the angle detection of the mirror portion 20 are improved as compared with the related art.

[Modification Example]

Next, a modification example of the embodiment will be described. In the above embodiment, the driving control unit 4 causes the mirror portion 20 to perform the precession, which is a motion in which the normal line N of the reflecting surface 20A is deflected such that a circle is drawn about the rotation axis C (see Fig. 11). In the present modification example, the mirror portion 20 is moved such that the normal line N of the reflecting surface 20A draws a spiral shape about the rotation axis C. Hereinafter, this motion is referred to as spiral motion.

In order to cause the mirror portion 20 to perform spiral motion, the amplitude voltages $V_1$ and $V_2$ need only be decreased or increased at a constant rate with the passage of time t in the first driving signal and the second driving signal shown in Fig. 9.

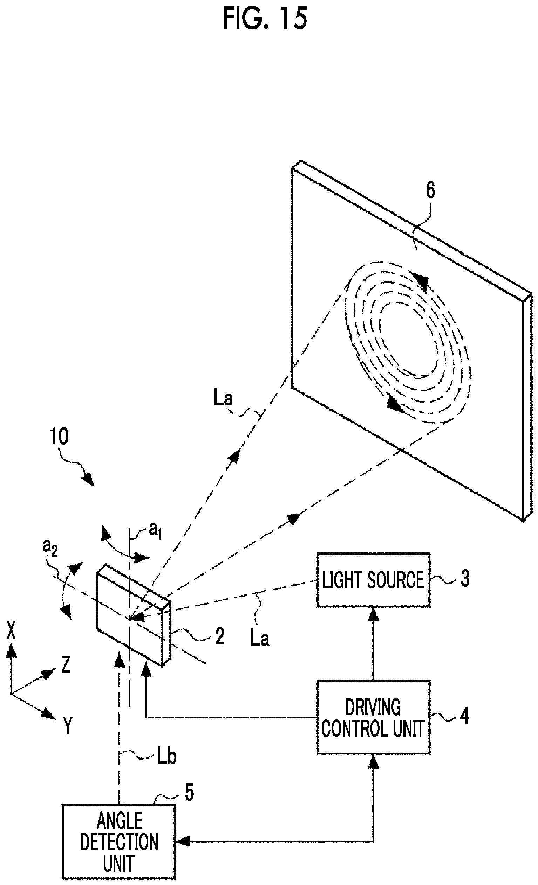

As shown in Fig. 15, in the present modification example, the mirror portion 20 performs the spiral motion, so that the surface to be scanned 6 is scanned with the light beam La reflected by the mirror portion 20 such that a spiral shape is drawn on the surface to be scanned 6.

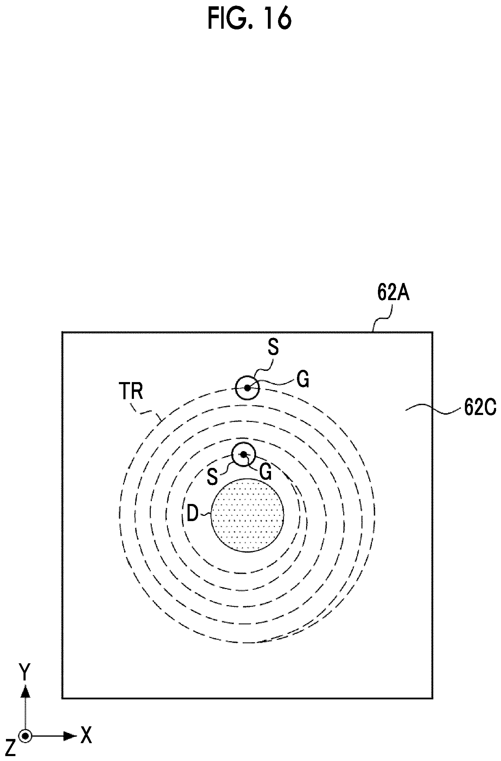

In the present modification example, Fig. 16 shows the trajectory of the light beam Lb incident on the light-receiving surface 62C of the position detector 62. In the present modification example, the trajectory TR at the light quantity centroid position has a spiral shape. The trajectory TR orbits around the shadow D of the light deflector 61 and does not intersect with the shadow D. Therefore, the position detector 62 accurately detects the two-dimensional coordinates of the light beam Lb incident on the light-receiving surface 62C. As described above, even in a case where the mirror portion 20 performs the spiral motion, the efficiency and accuracy of the angle detection of the mirror portion 20 are improved as compared with the related art.

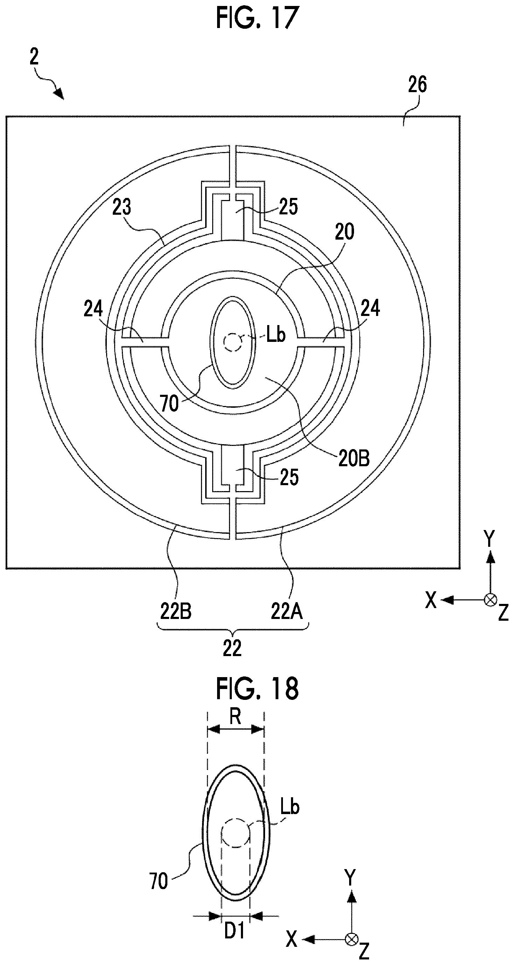

Fig. 17 shows an example of a configuration on a back surface side of the MMD 2. As shown in Fig. 17, an elliptical structure 70 may be provided on the back surface 20B of the mirror portion 20. The structure 70 is a so-called rib, and is formed by etching the above-described first silicon active layer 31. In Fig. 17, the structure 70 is disposed such that the center of the ellipse matches the center of the back surface 20B. A minor axis of the structure 70 is parallel to the X direction, and a major axis thereof is parallel to the Y direction.

A resonance frequency around the first axis $a_1$ and a resonance frequency around the second axis $a_2$ of the mirror portion 20 change according to the shape of the structure 70. Therefore, lengths of the structure 70 in a minor axis direction and a major axis direction are determined such that the resonance frequency around the first axis $a_1$ and the resonance frequency around the second axis $a_2$ of the mirror portion 20 match each other.

The light beam Lb deflected by the light deflector 61 is incident on the back surface 20B of the mirror portion 20 and is incident into an inner region of the structure 70 via the second optical system 64.

Fig. 18 shows a relationship between the size of the structure 70 on the back surface 20B of the mirror portion 20 and the beam diameter D1 of the light beam Lb. As shown in Fig. 18, the beam diameter D1 is smaller than an inner diameter R of the structure 70 in the minor axis direction. That is, a relationship of D1 < R is satisfied.

In Figs. 17 and 18, the structure 70 has an elliptical shape, but the structure 70 is not limited to the elliptical shape, and may have an oval shape, a rectangular shape, or the like.

In the above embodiment, although the light source 60 included in the position detector 62 is provided separately from the light source 3 that irradiates the reflecting surface 20A of the mirror portion 20 with the light beam La, the light source 60 and the light source 3 may be made common. For example, without providing the light source 60, a part of the light beam La emitted from the light source 3 may be made incident into the light deflector 61 as the light beam Lb for angle detection.

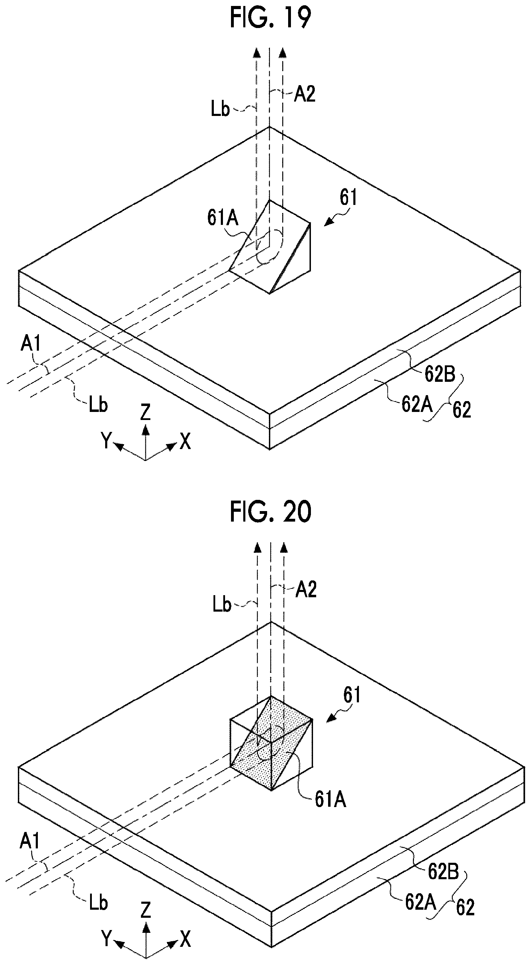

In addition, in the above-described embodiment, since the light deflector 61 has the reflecting surface 61A that is the cut surface formed by cutting the base material of the cylinder obliquely with respect to the rotational symmetry axis of the cylinder, a shape of the reflecting surface 61A is the elliptical shape. The reflecting surface 61A is not limited to the elliptical shape, and may have a square shape, the rectangular shape, or other shapes. As shown in Fig. 19 as an example, the light deflector 61 may have the rectangular reflecting surface 61A formed by obliquely cutting a base material of a cube.

In addition, the light deflector 61 may be an optical element such as a prism or the beam splitter. As shown in Fig. 20 as an example, the light deflector 61 may be a cube-type beam splitter. The cube-type beam splitter is configured by bonding slopes of two right-angle prisms to each other. An optical thin film is deposited on a bonding surface. The bonding surface constitutes the reflecting surface 61A.

The configuration of the MMD 2 shown in the above embodiment can be changed as appropriate. For example, in the above embodiment, although the first actuator 21 and the second actuator 22 have an annular shape, one or both of the first actuator 21 and the second actuator 22 may have a meander structure. In addition, it is possible to use a support member having a configuration other than a torsion bar as the first support portion 24 and the second support portion 25.

The hardware configuration of the driving control unit 4 can be variously modified. A processing unit of the driving control unit 4 may be configured of one processor, or may be configured of a combination of two or more processors of the same type or different types (for example, a combination of a plurality of field programmable gate arrays (FPGAs) and/or a combination of a CPU and an FPGA).

All documents, patent applications, and technical standards mentioned in this specification are incorporated herein by reference to the same extent as in a case where each document, each patent application, and each technical standard are specifically and individually described by being incorporated by reference.

## Claims

1. An optical scanning device comprising:

   a micromirror device including

   a mirror portion that has a reflecting surface for reflecting incident light,
   a first actuator that allows the mirror portion to swing around a first axis parallel to the reflecting surface in a case where the mirror portion is stationary, and
   a second actuator that allows the mirror portion to swing around a second axis parallel to the reflecting surface and orthogonal to the first axis;

   a light source that emits a light beam;
   a light deflector that deflects the light beam emitted from the light source;
   an optical system that guides the light beam deflected by the light deflector to a back surface of the mirror portion, which is a surface opposite to the reflecting surface; and
   a position detector that detects a position of the light beam deflected by the back surface.

2. The optical scanning device according to claim 1, further comprising:
   a processor that causes the mirror portion to perform precession or spiral motion by providing a first driving signal and a second driving signal having the same driving frequency to the first actuator and the second actuator, respectively.

3. The optical scanning device according to claim 2,

   wherein the light deflector has a surface mirror formed by depositing a metal thin film or a dielectric multi-layer film on a surface of a base material, and
   the light deflector deflects the light beam emitted from the light source by reflecting the light beam by the surface mirror.

4. The optical scanning device according to claim 3,

   wherein the base material is a cylinder, and
   the surface mirror is formed on a cut surface formed by cutting the base material obliquely with respect to a rotational symmetry axis of the cylinder.

5. The optical scanning device according to any one of claims 1 to 4,
   wherein the first actuator and the second actuator are piezoelectric actuators each including a piezoelectric element.

**6.** The optical scanning device according to any one of claims 1 to 5,

wherein the light beam deflected by the back surface is incident into the optical system, and the optical system guides the incident light beam to a light-receiving surface of the position detector.

**7.** The optical scanning device according to claim 6, wherein the optical system always makes the incident light beam be incident on the light-receiving surface.

**8.** The optical scanning device according to claim 6 or 7, wherein a beam diameter of the light beam on the back surface is larger than a beam diameter of the light beam on the light-receiving surface.

**9.** The optical scanning device according to any one of claims 1 to 8,

wherein an elliptical structure is formed on the back surface,
the light beam is incident into an inner region of the structure, and
a beam diameter of the light beam on the back surface is smaller than an inner diameter of the structure in a minor axis direction.

**10.** The optical scanning device according to any one of claims 1 to 9,
wherein the position detector is a sensor that detects a light quantity centroid position of the light beam.

# FIG. 1

# FIG. 2

# FIG. 3

FIG. 4

# FIG. 5

EP 4 411 451 A1

EP 4 411 451 A1

# FIG. 6

## FIG. 7

EP 4 411 451 A1

# FIG. 8

EP 4 411 451 A1

# FIG. 9

EP 4 411 451 A1

FIG. 10

DEFLECTION
ANGLE

$\theta_1$  $\theta_2$

$\theta_{m1}$      $\theta_{m2}$

0

$\phi$

t

FIG. 11

C

N

20  20A

Z
Y
X

20

# FIG. 12

# FIG. 13

# FIG. 14

# FIG. 15

# FIG. 16

## FIG. 17

## FIG. 18

# FIG. 19

# FIG. 20

## INTERNATIONAL SEARCH REPORT

| International application No. |
|---|
| **PCT/JP2022/033041** |

**A. CLASSIFICATION OF SUBJECT MATTER**

*G02B 26/10*(2006.01)i; *B81B 3/00*(2006.01)i; *G02B 26/08*(2006.01)i
FI: G02B26/10 104Z; G02B26/08 E; B81B3/00

According to International Patent Classification (IPC) or to both national classification and IPC

**B. FIELDS SEARCHED**

Minimum documentation searched (classification system followed by classification symbols)

G02B26/10; B81B3/00; G02B26/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2002-148536 A (OLYMPUS OPTICAL CO LTD) 22 May 2002 (2002-05-22) paragraphs [0008]-[0009], [0013], [0048]-[0060], fig. 5, 7 | 1-5, 9-10 |
| A | paragraphs [0008]-[0009], [0013], [0048]-[0060], fig. 5, 7 | 6-8 |
| Y | US 2012/0236379 A1 (LIGHTTIME, LLC) 20 September 2012 (2012-09-20) paragraphs [0028]-[0044], fig. 3 | 1-5, 9-10 |
| Y | JP 2019-074375 A (RICOH CO LTD) 16 May 2019 (2019-05-16) paragraphs [0033]-[0043], fig. 2 | 1-5, 9-10 |
| Y | JP 2017-173622 A (PIONEER ELECTRONIC CORP) 28 September 2017 (2017-09-28) paragraphs [0045]-[0052], fig. 1, 4 | 2-4 |
| Y | JP 2013-179085 A (SEIKO EPSON CORP) 09 September 2013 (2013-09-09) paragraph [0030] | 3-4 |
| Y | JP 59-133519 A (THOMSON-CSF) 31 July 1984 (1984-07-31) p. 3, lower left column, line 10 to p. 3, lower right column, line 3, fig. 2 | 4 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 September 2022** | **18 October 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/033041**

### C. DOCUMENTS CONSIDERED TO BE RELEVANT

| Category* | Citation of document, with indication, where appropriate, of the relevant passages | Relevant to claim No. |
|---|---|---|
| Y | JP 2019-020698 A (HAMAMATSU PHOTONICS KK) 07 February 2019 (2019-02-07)<br>paragraph [0068] | 9 |
| Y | JP 03-288120 A (RICOH CO LTD) 18 December 1991 (1991-12-18)<br>p. 3, upper right column, lines 14-16 | 10 |
| Y | JP 2011-112744 A (RICOH CO LTD) 09 June 2011 (2011-06-09)<br>paragraph [0027] | 10 |
| A | JP 2008-116678 A (SONY CORP) 22 May 2008 (2008-05-22)<br>entire text, all drawings | 1-10 |
| A | WO 2019/176204 A1 (MITSUBISHI ELECTRIC CORPORATION) 19 September 2019<br>(2019-09-19)<br>entire text, all drawings | 1-10 |

Form PCT/ISA/210 (second sheet) (January 2015)

**INTERNATIONAL SEARCH REPORT**
Information on patent family members

International application No.

**PCT/JP2022/033041**

| Patent document cited in search report | | | Publication date (day/month/year) | Patent family member(s) | | | Publication date (day/month/year) |
|---|---|---|---|---|---|---|---|
| JP | 2002-148536 | A | 22 May 2002 | (Family: none) | | | |
| US | 2012/0236379 | A1 | 20 September 2012 | WO | 2012/027410 | A1 | |
| JP | 2019-074375 | A | 16 May 2019 | (Family: none) | | | |
| JP | 2017-173622 | A | 28 September 2017 | (Family: none) | | | |
| JP | 2013-179085 | A | 09 September 2013 | US paragraph [0047] | 2009/0190102 | A1 | |
| JP | 59-133519 | A | 31 July 1984 | US column 2, lines 35-49, fig. 2 EP | 4547650 112224 | A A1 | |
| JP | 2019-020698 | A | 07 February 2019 | US paragraph [0078] WO EP CN KR | 2020/0209611 2019/017130 3657231 110799890 10-2020-0029395 | A1 A1 A1 A A | |
| JP | 03-288120 | A | 18 December 1991 | (Family: none) | | | |
| JP | 2011-112744 | A | 09 June 2011 | (Family: none) | | | |
| JP | 2008-116678 | A | 22 May 2008 | (Family: none) | | | |
| WO | 2019/176204 | A1 | 19 September 2019 | US entire text, all drawings EP CN | 2021/0011282 3767367 111819486 | A1 A1 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2012198511 A